# EUROPEAN PATENT APPLICATION

(11) **EP 4 716 399 A1**
(43) Date of publication of application: **25.03.2026**
(21) Application number: 25793290.5
(22) Date of filing: 13.03.2025
(51) Int. Cl.: H10B 12/00

(54) **METHOD FOR PREPARING SEMICONDUCTOR STRUCTURE AND SEMICONDUCTOR STRUCTURE THEREOF**

(30) Priority: 25.04.2024 CN 202410510599
(71) Applicant: CXMT Corporation, Hefei City, Anhui Province 230601 (CN)
(72) Inventor: WANG, Ruiming, Hefei, Anhui 230601 (CN); WANG, Jiaping, Hefei, Anhui 230601 (CN)
(74) Representative: Gulde & Partner
(86) International application number: PCT/CN2025/082243
(87) International publication number: WO 2025/223092

(57) **Abstract**

A method for manufacturing a semiconductor structure and a semiconductor structure are provided. The method includes: providing a base substrate; forming a stack structure on the base substrate, where the stack structure is formed by stacking first dielectric layers and second dielectric layers; forming first openings, where a plurality of first openings are spaced apart in a second direction; forming initial active pillars; forming second openings, where the second opening is located between adjacent initial active pillars, the dimension of the second opening in the second direction is less than the distance between the adjacent initial active pillars; removing parts of the initial active pillars to form active pillars; forming word line structures, where the word line structure is disposed on one side of the active pillar; forming bit line structures, where the bit line structure is electrically connected to one end of the active pillar; forming capacitor structures, where the capacitor structure is electrically connected to the other end of the active pillar.

## Description

### CROSS-REFERENCE

The present application claims priority to Chinese Patent Application No. 202410510599.7 filed on April 25, 2024, and entitled "METHOD FOR MANUFACTURING SEMICONDUCTOR STRUCTURE AND SEMICONDUCTOR STRUCTURE", the content of which is incorporated herein by reference in its entirety.

### TECHNICAL FIELD

Embodiments of the present disclosure relate to the field of semiconductors, in particular, to a method for manufacturing a semiconductor structure and a semiconductor structure.

### BACKGROUND

As dynamic random access memories (DRAMs) develop, they are expected to have such performance indicators as high speed, high integration density, and low power consumption. With the miniaturization of structures of semiconductor devices, technical barriers to existing structures are increasingly obvious. Therefore, it is an advantageous way to break the existing technical barriers by developing more novel structures on the basis of the existing structures.

The advent of three-dimensional dynamic random access memories (3D DRAMs) has satisfied the above-mentioned need. However, the existing 3D DRAM manufacturing process is complex, affecting the performance and yield of the semiconductor structure.

### SUMMARY

Embodiments of the present disclosure provide a method for manufacturing a semiconductor structure and a semiconductor structure, which can at least help to simplify the manufacturing process and improve the performance and yield of semiconductor memory devices.

According to some embodiments of the present disclosure, an aspect of the embodiments of the present disclosure provides a method for manufacturing a semiconductor structure. The method includes:
providing a base substrate; forming a stack structure on the base substrate, where the stack structure is formed by stacking first dielectric layers and second dielectric layers in a third direction, where the third direction is perpendicular to a surface of the base substrate;
forming at least one first opening, where the first opening extends from a top of the stack structure to a top of the base substrate in the third direction, and a plurality of first openings are spaced apart in a second direction, where the second direction is parallel to the surface of the base substrate, and the second direction is perpendicular to the third direction;
forming initial active pillars, where each of the initial active pillars fills one of the plurality of first openings;
forming second openings, where each of the second openings is located between adjacent initial active pillars, a dimension of the second opening in the second direction is less than a distance between the adjacent initial active pillars, a first distance is present between the second opening and one of the initial active pillars, and the second opening extends from the top of the stack structure to the top of the base substrate in the third direction;
removing parts of the initial active pillars to form active pillars, where the active pillars are spaced apart in both the second direction and the third direction;
forming word line structures, where each of the word line structures is disposed on one side of one of the active pillars and extends in the third direction;
forming bit line structures, where each of the bit line structures is electrically connected to one end of one of the active pillars, and the bit line structure extends in the second direction; and
forming capacitor structures, where each of the capacitor structures is electrically connected to the other end of one of the active pillars, and the capacitor structure extends in a first direction, where the first direction is perpendicular to a plane formed with the third direction and the second direction.

In some embodiments, both ends of each of the second openings in the first direction are aligned with both ends of one of the initial active pillars in the first direction; or one end of the second opening in the first direction is aligned with one end of the initial active pillar closest to one edge of the stack structure, and the other end of the second opening extends to the other edge of the stack structure in the first direction.

In some embodiments, removing parts of the initial active pillars to form the active pillars specifically includes: exposing, by the second openings, the stack structure surrounding the initial active pillars, and etching and removing parts of the first dielectric layers on side walls of the initial active pillars to form notches, where the notches expose the side walls of the initial active pillars, and the notches are spaced apart in the third direction; and
etching the initial active pillars to form the active pillars through the notches, where the active pillars form gaps in the third direction, side walls of the active pillars are covered by the second dielectric layers, and the notches, the gaps, and the second openings together form a third opening.

In some embodiments, the method further includes: after forming the active pillars and before forming the word line structures, forming a third dielectric layer, where the third dielectric layer fills the third opening;
forming fourth openings, where each of the fourth openings is adjacent to one side of one of the active pillars and exposes part of the side wall of the active pillar, a second distance is present between the fourth opening and a non-adjacent active pillar, and the fourth opening extends to a bottom of the stack structure in the third direction; and forming one of the word line structures in each of the fourth openings.

In some embodiments, forming the bit line structures specifically includes: removing the second dielectric layers at one end of the active pillars to form first recesses; doping one end of the active pillars through the first recesses to form first doped regions; and forming one of the bit line structures in each of the first recesses, where each of the bit line structures is electrically connected to one of the first doped regions.

In some embodiments, forming the capacitor structures specifically includes: removing the second dielectric layers at the other end of the active pillars to form second recesses; doping the other end of the active pillars through the second recesses to form second doped regions; and forming one of the capacitor structures in each of the second recesses, where each of the capacitor structures is electrically connected to one of the second doped regions.

In some embodiments, the initial active pillars are generated through an epitaxial process, and a cross section of each of the active pillars in the second direction may be quadrilateral or hexagonal.

Another aspect of the embodiments of the present disclosure provides a semiconductor structure. The semiconductor structure includes:
a base substrate; a plurality of word line structures perpendicular to the base substrate, where the plurality of word line structures are spaced apart in a second direction;
a plurality of active pillars, where the plurality of active pillars extend in a first direction; the plurality of active pillars are spaced apart in both the second direction and a third direction, the third direction being perpendicular to the first direction and the second direction; and each of the plurality of word line structures is disposed proximal to one side of one of the plurality of active pillars;
a plurality of bit line structures, where the plurality of bit line structures extend in the second direction and are spaced apart in the third direction, and each of the plurality of bit line structures is electrically connected to one end of one of the plurality of active pillars; and
a plurality of capacitor structures, where the plurality of capacitor structures extend in the first direction and are spaced apart in both the second direction and the third direction, and each of the plurality of capacitor structures is electrically connected to the other end of one of the plurality of active pillars.

In some embodiments, multiple active pillars spaced apart in the second direction among the plurality of active pillars are electrically connected to a same bit line structure, and each of the multiple active pillars is electrically connected to one capacitor structure; the active pillars electrically connected to the same bit line structure, the capacitor structure electrically connected to the active pillar, and the bit line structure are all located at the same tier.

In some embodiments, the semiconductor structure further includes: first doped regions, where each of the first doped regions is located at one end of one of the plurality of active pillars and electrically connected to one of the plurality of bit line structures; and second doped regions, where each of the second doped regions is located at the other end of one of the plurality of active pillars and electrically connected to one of the plurality of capacitor structures.

In some embodiments, the semiconductor structure further includes: channel regions each disposed proximal to one of the plurality of word line structures, where each of the channel regions is located on one of the plurality of active pillars between one of the first doped regions and one of the second doped regions and proximal to one of the plurality of word line structures.

In some embodiments, a cross section of each of the plurality of active pillars in the second direction may be quadrilateral or hexagonal.

According to the technical solutions of the embodiments of the present disclosure, a stack structure is provided, first openings and second openings are formed on the stack structure, initial active pillars are formed in the first openings, and the initial active pillars are etched away to form active pillars spaced apart in both a second direction and a third direction through the second openings, such that the forming process of the active pillar is simplified compared with the prior art. In addition, by using this method, a source/drain region, a bit line structure, and a word line structure can be formed subsequently with self-alignment, such that the process is further simplified, thereby improving the yield of the semiconductor structure and further enhancing the device performance.

### BRIEF DESCRIPTION OF DRAWINGS

One or more embodiments are exemplarily illustrated with reference to figures in the corresponding drawings, and these exemplary illustrations are not to be construed as limiting the embodiments. Unless expressly stated otherwise, the figures in the drawings do not constitute a limitation of scale. To more clearly illustrate the technical solutions in the embodiments of the present disclosure or conventional technology, a brief introduction to the drawings required to be used in the embodiments is given hereinafter. It is evident that the drawings described hereinafter are merely some embodiments of the present disclosure. For those of ordinary skill in the art, other drawings may be further obtained based on these drawings without creative effort.
FIG. 1 is a flow block diagram of a method for manufacturing a semiconductor structure according to an embodiment of the present disclosure.
FIGS. 2 to 14 are top views of process flow diagrams of a semiconductor structure according to an embodiment of the present disclosure.
FIG. 2A, FIG. 3A, FIG. 4A, FIG. 8A, FIG. 11A, FIG. 12A, FIG. 13A, and FIG. 14A are schematic diagrams of cross-sectional structures taken in the direction of A-A' in FIG. 2, FIG. 3, FIG. 4, FIG. 8, FIG. 11, FIG. 12, FIG. 13, and FIG. 14, respectively;
FIG. 2B, FIG. 3B, FIG. 4B, FIG. 5B, FIG. 6B, FIG. 7B, FIG. 8B, FIG. 9B, FIG. 10B, FIG. 11B, FIG. 12B, FIG. 13B, and FIG. 14B are schematic diagrams of cross-sectional structures taken in the direction of B-B' in FIG. 2, FIG. 3, FIG. 4, FIG. 5, FIG. 6, FIG. 7, FIG. 8, FIG. 9, FIG. 10, FIG. 11, FIG. 12, FIG. 13, and FIG. 14, respectively;
FIG. 5A, FIG. 6A, FIG. 7A, FIG. 8C, FIG. 9A, and FIG. 10A are schematic diagrams of cross-sectional structures taken in the direction of C-C' in FIG. 5, FIG. 6, FIG. 7, FIG. 8, FIG. 9, and FIG. 10, respectively.
FIGS. 15 to 24 are top views of process flow diagrams of a semiconductor structure according to another embodiment of the present disclosure.
FIG. 18A, FIG. 21A, FIG. 22A, FIG. 23A, and FIG. 24A are schematic diagrams of cross-sectional structures taken in the direction of A-A' in FIG. 18, FIG. 21, FIG. 22, FIG. 23, and FIG. 24, respectively;

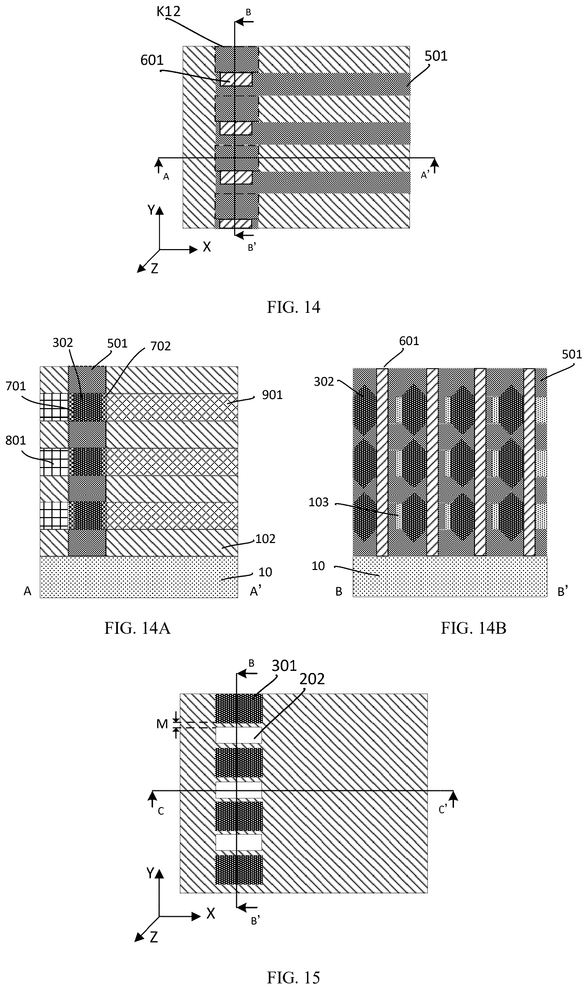

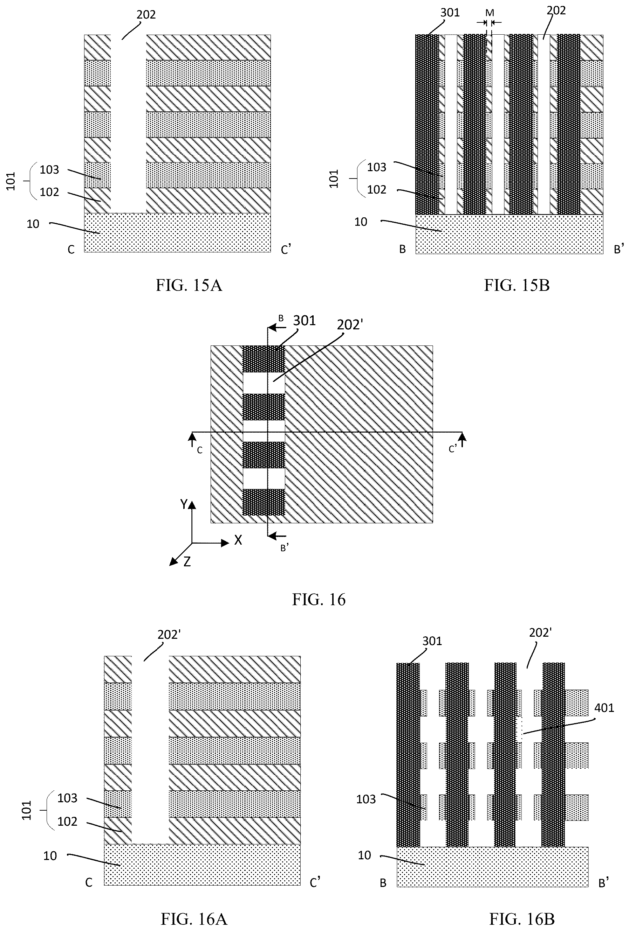

FIG. 15B, FIG. 16B, FIG. 17B, FIG. 18B, FIG. 19B, FIG. 20B, FIG. 21B, FIG. 22B, FIG. 23B, and FIG. 24B are schematic diagrams of cross-sectional structures taken in the direction of B-B' in FIG. 15, FIG. 16, FIG. 17, FIG. 18, FIG. 19, FIG. 20, FIG. 21, FIG. 22, FIG. 23, and FIG. 24, respectively;
FIG. 15A, FIG. 16A, FIG. 17A, FIG. 18C, FIG. 19A, and FIG. 20A are schematic diagrams of cross-sectional structures taken in the direction of C-C' in FIG. 15, FIG. 16, FIG. 17, FIG. 18, FIG. 19, and FIG. 20, respectively.

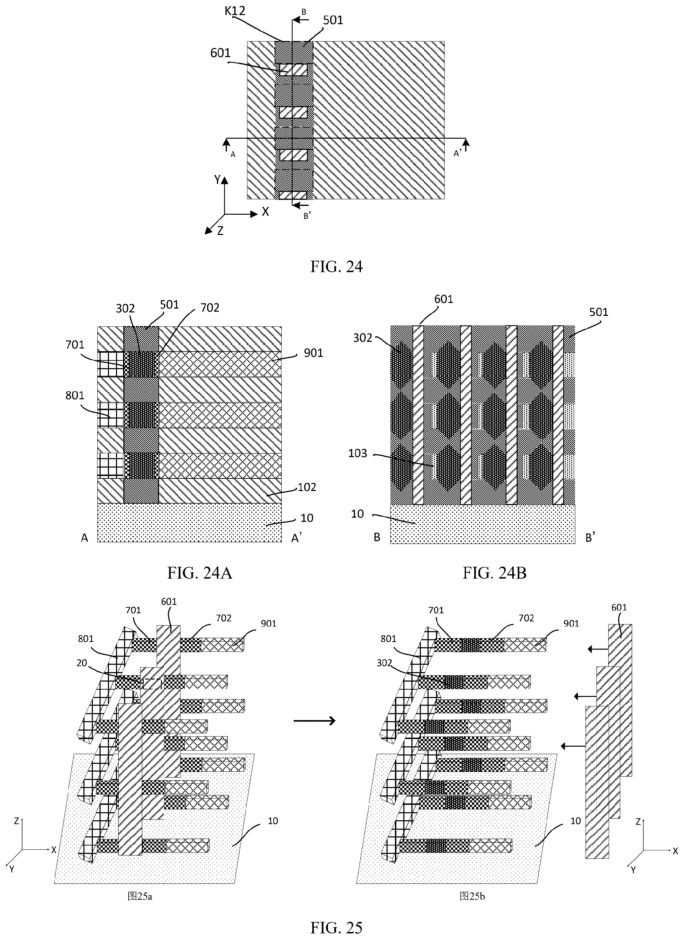

FIG. 25 is a three-dimensional schematic diagram of a semiconductor structure according to an embodiment of the present disclosure. FIG. 25a is a three-dimensional schematic diagram of an overall structure; FIG. 25b is an exploded diagram of FIG. 25a.

### DESCRIPTION OF EMBODIMENTS

The technical solutions of the present disclosure will be further elaborated below with reference to the drawings and embodiments. While exemplary implementations of the present disclosure are shown in the drawings, it should be understood that the present disclosure may be implemented in various forms and should not be limited by the embodiments set forth herein. Rather, these embodiments are provided such that the present disclosure will be more thoroughly understood and the scope of the present disclosure will be fully conveyed to those skilled in the art.

The present disclosure is more specifically described in the following paragraphs with reference to the drawings by way of example. The advantages and features of the present disclosure will become clearer from the following description and claims. It should be noted that the drawings are all in a very simplified form and not to a precise scale, and are provided only for the purpose of facilitating a convenient and clear description of the embodiments of the present disclosure.

It will be understood that the meaning of "on", "above", and "over" in the present disclosure should be interpreted in the broadest manner such that "on" not only includes the meaning of "on" something with no intermediate feature or layer therebetween (i.e., directly on something) but also includes the meaning of "on" something with an intermediate feature or a layer therebetween.

In the embodiments of the present disclosure, the terms "first", "second", "third", and the like are used for distinguishing similar objects and are not necessarily used for describing a particular order or sequence.

In the embodiments of the present disclosure, the term "layer" refers to a material portion that includes a region having a thickness. A layer may extend over the entirety of the underlying or overlying structure or may have an extent that is less than the extent of the underlying or overlying structure. Furthermore, a layer may be a region of a homogeneous or inhomogeneous continuous structure having a thickness less than the thickness of a continuous structure. For example, a layer may be located between the top surface and the bottom surface of a continuous structure, or a layer may be located between any pair of horizontal planes at the top surface and the bottom surface of the continuous structure. A layer may extend horizontally, perpendicularly, and/or along inclined surfaces. A layer may include a plurality of sub-layers.

It should be noted that unless conflicting, the technical solutions described in the embodiments of the present disclosure may be arbitrarily combined.

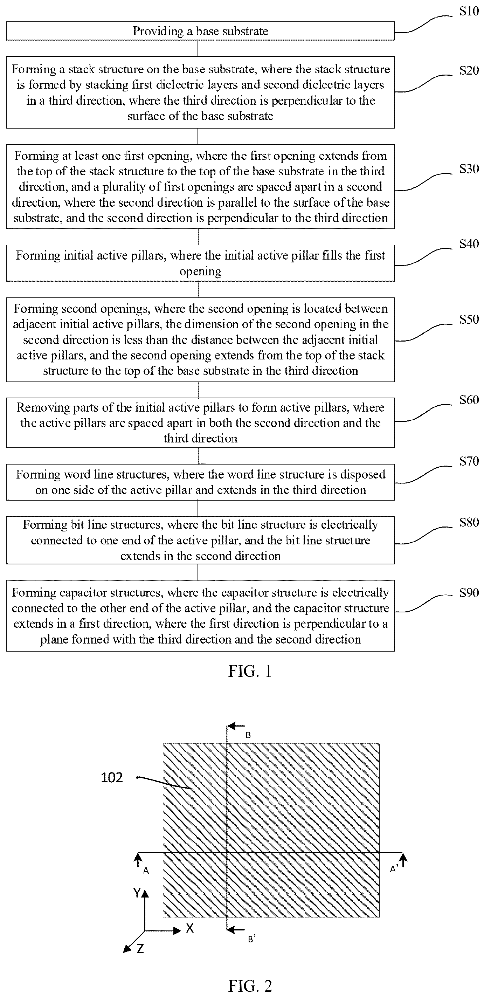

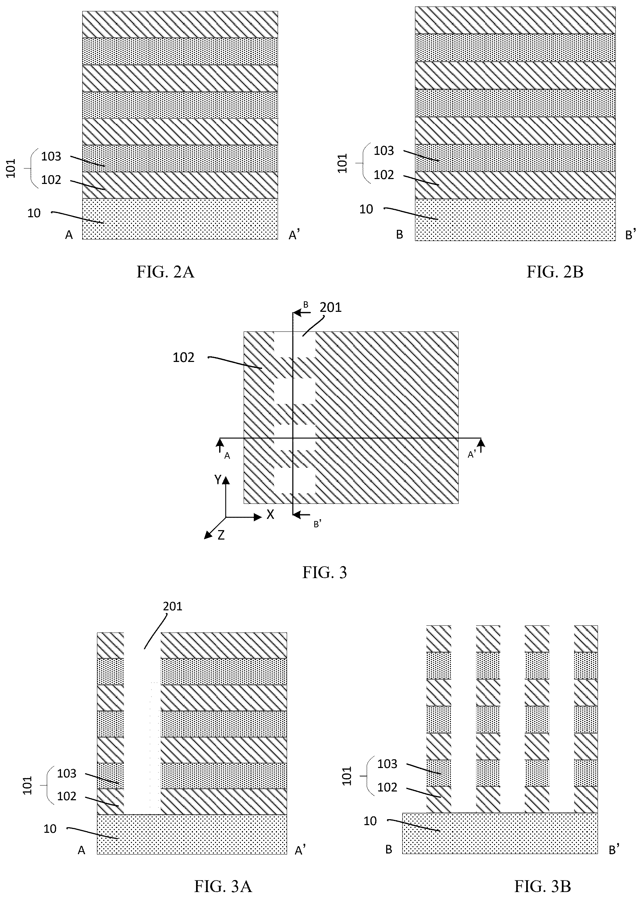

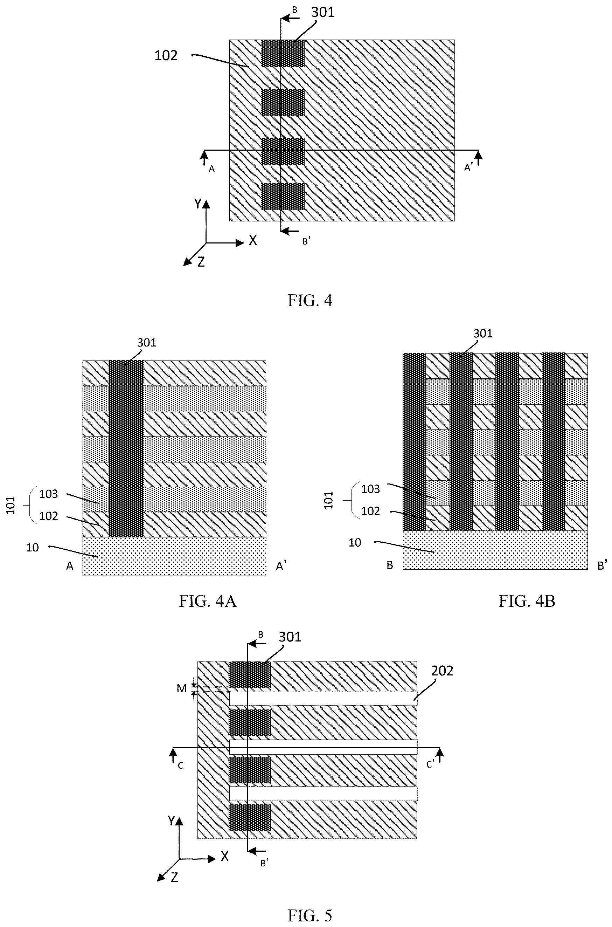

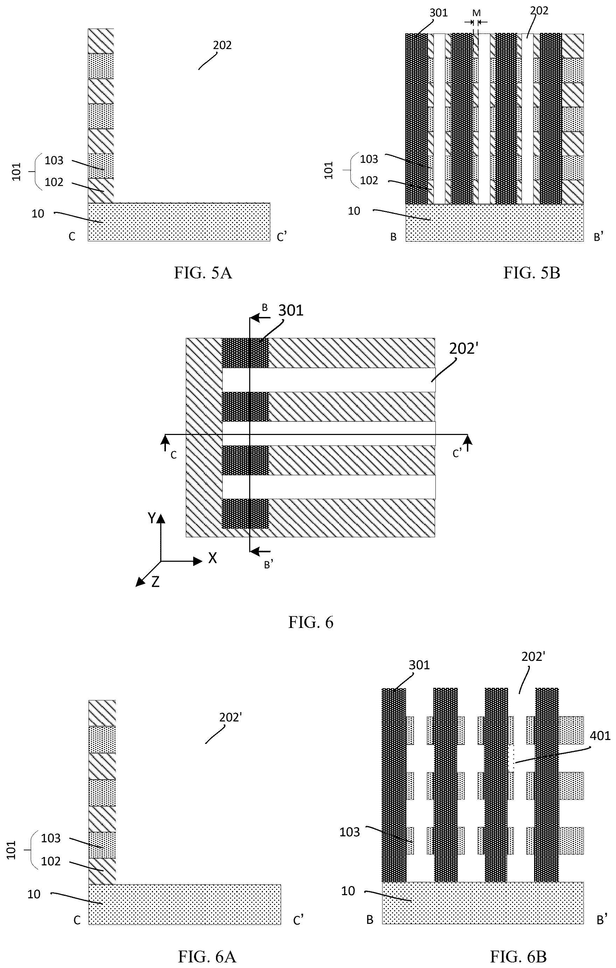

FIG. 1 is a flow block diagram of a method for manufacturing a semiconductor structure according to an embodiment of the present disclosure; FIGS. 2 to 14 are top views of process flow diagrams of a semiconductor structure according to an embodiment of the present disclosure; FIG. 2A, FIG. 3A, FIG. 4A, FIG. 8A, FIG. 11A, FIG. 12A, FIG. 13A, and FIG. 14A are schematic diagrams of cross-sectional structures taken in the direction of A-A' in FIG. 2, FIG. 3, FIG. 4, FIG. 8, FIG. 11, FIG. 12, FIG. 13, and FIG. 14, respectively; FIG. 2B, FIG. 3B, FIG. 4B, FIG. 5B, FIG. 6B, FIG. 7B, FIG. 8B, FIG. 9B, FIG. 10B, FIG. 11B, FIG. 12B, FIG. 13B, and FIG. 14B are schematic diagrams of cross-sectional structures taken in the direction of B-B' in FIG. 2, FIG. 3, FIG. 4, FIG. 5, FIG. 6, FIG. 7, FIG. 8, FIG. 9, FIG. 10, FIG. 11, FIG. 12, FIG. 13, and FIG. 14, respectively; FIG. 5A, FIG. 6A, FIG. 7A, FIG. 8C, FIG. 9A, and FIG. 10A are schematic diagrams of cross-sectional structures taken in the direction of C-C' in FIG. 5, FIG. 6, FIG. 7, FIG. 8, FIG. 9, and FIG. 10, respectively.

The manufacturing method at least includes the following steps: In S10, a base substrate is provided. In S20, a stack structure is formed on the base substrate, where the stack structure is formed by stacking first dielectric layers and second dielectric layers in a third direction, where the third direction is perpendicular to the surface of the base substrate. In S30, at least one first opening is formed, where the first opening extends from the top of the stack structure to the top of the base substrate in the third direction, and a plurality of first openings are spaced apart in a second direction, where the second direction is parallel to the surface of the base substrate, and the second direction is perpendicular to the third direction. In S40, initial active pillars are formed, where the initial active pillar fills the first opening. In S50, second openings are formed, where the second opening is located between adjacent initial active pillars, the dimension of the second opening in the second direction is less than the distance between the adjacent initial active pillars, and the second opening extends from the top of the stack structure to the top of the base substrate in the third direction. In S60, parts of the initial active pillars are removed to form active pillars, where the active pillars are spaced apart in both the second direction and the third direction. In S70, word line structures are formed, where the word line structure is disposed on one side of the active pillar and extends in the third direction. In S80, bit line structures are formed, where the bit line structure is electrically connected to one end of the active pillar, and the bit line structure extends in the second direction. In S90, capacitor structures are formed, where the capacitor structure is electrically connected to the other end of the active pillar, and the capacitor structure extends in a first direction, where the first direction is perpendicular to a plane formed with the third direction and the second direction.

One embodiment of the present disclosure is described in more detail below with reference to the drawings.

Referring to FIG. 2, FIG. 2A, and FIG. 2B, a base substrate 10 is provided. A stack structure 101 is formed on the base substrate 10. The stack structure 101 is formed by stacking first dielectric layers 102 and second dielectric layers 103 in a third direction Z. The third direction Z is perpendicular to the surface of the base substrate 10. The thicknesses of the first dielectric layer 102 and the second dielectric layer 103 in the third direction Z may be equal or unequal. In this embodiment, the thicknesses of the first dielectric layer 102 and the second dielectric layer 103 in the third direction Z are equal.

The material of the base substrate may be silicon (Si), germanium (Ge), silicon germanium (GeSi), or silicon carbide (SiC), or may be silicon-on-insulator (SOI) or germaniumon-insulator (GOI), or may also be another material, for example, a group III-V compound, for example, gallium arsenide. The material of the base substrate in this embodiment is silicon. The base substrate is doped with certain impurity ions as required, and the impurity ions may be N-typed impurity ions or P-typed impurity ions. The first dielectric layer 102 and the second dielectric layer 103 have different material compositions, and the second dielectric layer 103 may have an etching selectivity with respect to a first material 106. The first dielectric layer 102 may be one or more of the following materials: silicon dioxide (SiO2), phosphosilicate glass, borosilicate glass, borophosphosilicate glass, fluorosilicate glass, titanium dioxide (TiO2), hafnium oxide (HfO2), zirconium dioxide (ZrO2), hafnium dioxide (HfO2), tantalum oxide (TaO2), magnesium oxide (MgO), aluminum oxide (Al2O3), and the like. The second dielectric layer 103 may be one or more of the following materials: silicon nitride (Si3N4), oxynitride (SiON), silicon carbonitride (SiCN), silicon oxycarbonitride (SiOCN), and the like. In one embodiment, the first dielectric layer 102 may include silicon dioxide, and the second dielectric layer 103 may include silicon nitride. Methods for forming the first dielectric layer 102 and the second dielectric layer 103 include one of an atomic layer deposition (ALD) process, a plasma enhanced atomic layer deposition (PEALD) process, a chemical vapor deposition (CVD) process, and a plasma enhanced chemical vapor deposition (PECVD) process.

Referring to FIG. 3, FIG. 3A, and FIG. 3B, at least one first opening 201 is formed. The first opening 201 extends from the top of the stack structure 101 to the top of the base substrate 10 in the third direction Z, and a plurality of first openings 201 are spaced apart in a second direction Y; the second direction Y is parallel to the surface of the base substrate 10, and the second direction Y is perpendicular to the third direction Z. The first opening 201 is formed toward one side of the stack structure 101. As shown in FIG. 3 and FIG. 3A, the first opening 201 is formed toward the left side of the stack structure 101 in a first direction X, and certainly, the first opening 201 may also be formed toward the right side of the stack structure 101 in the first direction X. However, the first opening 201 cannot be formed at the central axis position of the stack structure 101. More space can be reserved for the subsequent formation of a capacitor structure by forming the opening toward one side. The distance of the first opening 201 toward one side may be set according to process requirements. The first openings 201 may be formed using a dry etching process.

Referring to FIG. 4, FIG. 4A, and FIG. 4B, initial active pillars 301 are formed. The initial active pillar 301 fills the first opening 201. The initial active pillar 301 may be formed through an epitaxial process, and specifically, the initial active pillar 301 is formed by epitaxial growth using the silicon base substrate 10 as the silicon source.

Referring to FIG. 5, FIG. 5A, and FIG. 5B, second openings 202 are formed. The second opening 202 is located between adjacent initial active pillars 301. The dimension of the second opening 202 in the second direction Y is less than the distance between adjacent initial active pillars 301. One end of the second opening 202 in the first direction X is aligned with one end of the initial active pillar 301 closest to one edge of the stack structure 101, and the other end of the second opening 202 extends to the other edge of the stack structure 101 in the first direction X. That is, as shown in FIG. 5, the left edge and the right edge of the stack structure 101 are present in the first direction X, the left side and the right side of the initial active pillar 301 are present in the first direction X, the leftmost side of the second opening 202 in the first direction X is aligned with the left side of the initial active pillar 301, and the rightmost side of the second opening 202 in the first direction X is aligned with the right edge of the stack structure 101. Certainly, the leftmost side and the rightmost side of the second opening 202 in the first direction X may be aligned with the left side and the right side of the initial active pillar 301, which will be described in detail in the next embodiment. In this embodiment, one end of the second opening 202 in the first direction X is aligned with one end of the initial active pillar 301 closest to one edge of the stack structure 101, and the other end of the second opening 202 extends to the other edge of the stack structure 101 in the first direction X.

A first distance M is present between the second opening 202 and the initial active pillar 301. The second opening 202 extends from the top of the stack structure 101 to the top of the base substrate 10 in the third direction Z. The second opening 202 is located between two adjacent initial active pillars 301 but does not expose the side walls of the initial active pillars 301. As shown in FIG. 5B, the stack structure 101 with the thickness of M is present on the left and right sides of the initial active pillar 301, and the stack structure 101 is formed by stacking the first dielectric layers 102 and the second dielectric layers 103. The presence of the first distance M may provide a basis for the subsequent generation of an active pillar.

Referring to FIG. 6, FIG. 6A, and FIG. 6B, the first dielectric layers 102 on the side wall of the initial active pillar 301 are etched and removed through the second opening 202 to form notches 401. The notch 401 exposes the side wall of the initial active pillar 301. The notches 401 are formed on both sides of the initial active pillar 301 and spaced apart in the third direction. The notches 401 further ream the second opening 202 to form an expanded second opening 202'.

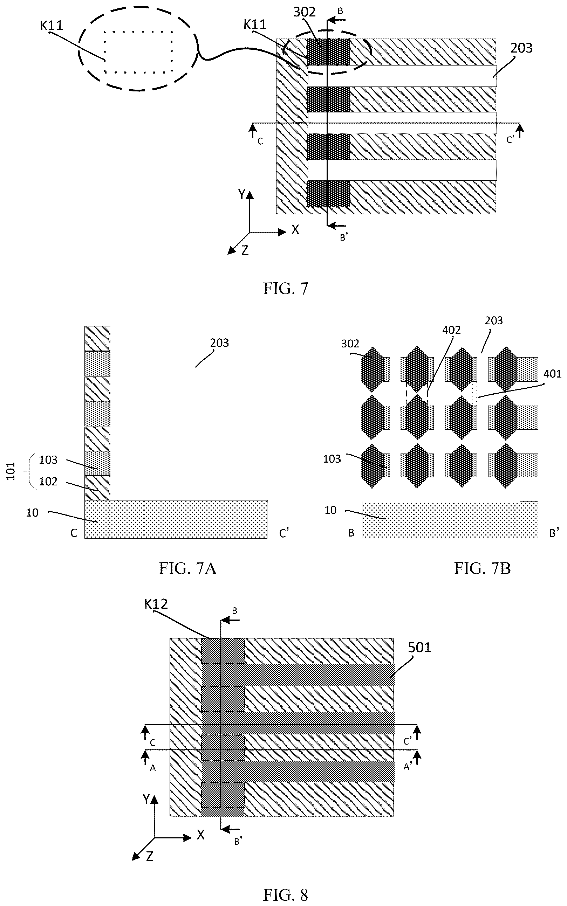

Referring to FIG. 7, FIG. 7A, and FIG. 7B, the initial active pillar 301 is etched to form an active pillar 302 through the notches 401. The active pillars 302 form gaps 402 in the third direction Z. The side walls of the active pillar 302 in the second direction Y are covered by the second dielectric layers 103. As shown in FIG. 5B, the second dielectric layer 103 with the thickness of M is present on the left and right sides of the initial active pillar 301, since the second dielectric layer 103 can protect the initial active pillar 301 from damage to the side walls during the process of etching the initial active pillar 301 to form the active pillar 302. In addition, the second dielectric layers 103 also provide self-alignment for the process of etching to form the active pillar 302. The difference in etching selectivities of the second dielectric layer 103 and the initial active pillar 301 enables the etching solution to etch only the initial active pillar 301 without etching the second dielectric layer 103, allowing the initial active pillar 301 to be etched away to form the active pillar 302. In some embodiments, the active pillar may also be generated by first forming the stack of silicon (Si) and silicon germanium (SiGe) and then completely removing the SiGe.

Referring to FIG. 5, FIG. 5A, and FIG. 5B, and referring to FIG. 7, FIG. 7A, and FIG. 7B, the notches 401, the gaps 402, and the second openings 202 together form a third opening 203. The cross section of the active pillar 302 in the second direction may be quadrilateral or hexagonal. As shown in FIG. 7B, the cross section of the active pillar 302 in the second direction is hexagonal. The initial active pillar 301 interposed between the second dielectric layers 103 is preferentially etched during the etching process mainly due to the blocking of the second dielectric layer 103 and the difference in etching selectivities of the second dielectric layer 103 and the initial active pillar 301. As the etching progresses, the etching rate slows down accordingly, such that the initial active pillar 301 forms a certain slope and eventually takes the shape of a hexagon as shown in FIG. 7B. Certainly, if the etching further progresses, the vertex corners of the hexagon at both ends distal to the second dielectric layer 103 may also be removed, thereby further forming a quadrilateral. The cross section of the active pillar 302 in the second direction is preferably hexagonal since the hexagon can provide more process space to increase the contact area in the subsequent process of forming a bit line structure and a capacitor structure on both ends of the active pillar, thereby further reducing the contact resistance. In addition, it should be noted that the dashed box K11 in the enlarged view in FIG. 7 indicates that since part of the top of the initial active pillar 301 is removed to form the gap 402, the active pillar 302 below can be seen through the gap 402, and the active pillar 302 shown in the dashed box K11 is an active pillar at the next layer.

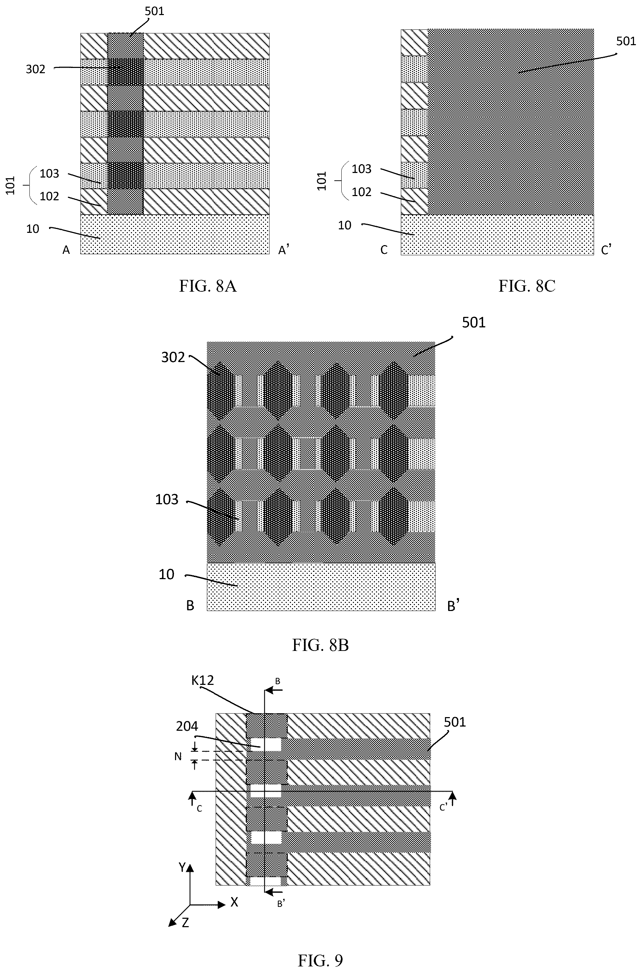

Referring to FIG. 8, FIG. 8A, FIG. 8C, and FIG. 8B, a third dielectric layer 501 is formed in the third opening 203. The third dielectric layer 501 fills the third opening 203. The dashed box K12 indicates the position of the active pillar 302 present below the third dielectric layer 501 after the third dielectric layer 501 is formed above. As shown in FIG. 8A, the second dielectric layer 103 is present on the left and right sides of the active pillar 302, the third dielectric layer 501 is present on the upper and lower sides of the active pillar 302, and the first dielectric layer 102 is present on the left and right sides of the third dielectric layer 501. The first dielectric layer 102 and the third dielectric layer 501 may be made of the same material or different materials, with the same material being preferred. If the materials of the first dielectric layer 102 and the third dielectric layer 501 are different, it is necessary to ensure that the etching selectivities of the first dielectric layer 102, the third dielectric layer 501, and the second dielectric layer 103 are large.

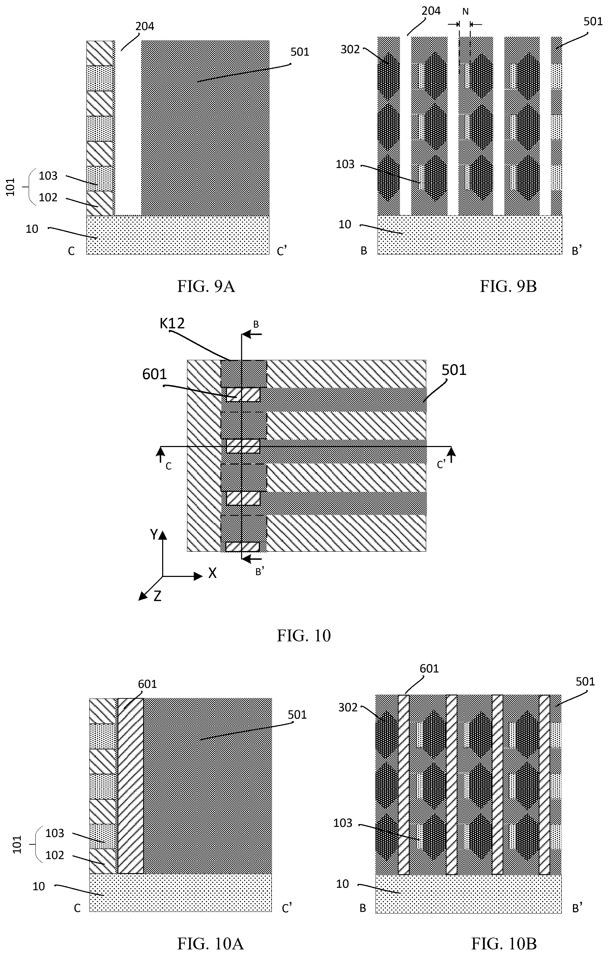

Referring to FIG. 9, FIG. 9A, and FIG. 9B, fourth openings 204 are formed. The fourth opening 204 is adjacent to one side of the active pillar 302 and exposes part of the side wall of the active pillar 302. A second distance N is present between the fourth opening 204 and a non-adjacent active pillar 302. The fourth opening 204 extends to the bottom of the stack structure 101 in the third direction Z.

Referring to FIG. 10, FIG. 10A, and FIG. 10B, word line structures 601 are formed in the fourth opening 204. The word line structure 601 is in contact with one side wall of the active pillar 302. As shown in the figure, the word line structure 601 is in contact with the right side wall of the active pillar 302, and in other embodiments, the word line structure 601 may be also in contact with the left side wall of the active pillar 302, which mainly depends on the position of the fourth opening 204. The arrangement of the word line structure 601 on either the left or right side of the active pillar 302 does not affect the performance of the word line structure itself, and the layout is mainly determined based on the performance requirements of the overall structure. It should be noted that before forming the word line structure 601, a gate dielectric layer is further formed in the fourth opening 204. That is, the gate dielectric layer is present between the word line structure 601 and the active pillar 302.

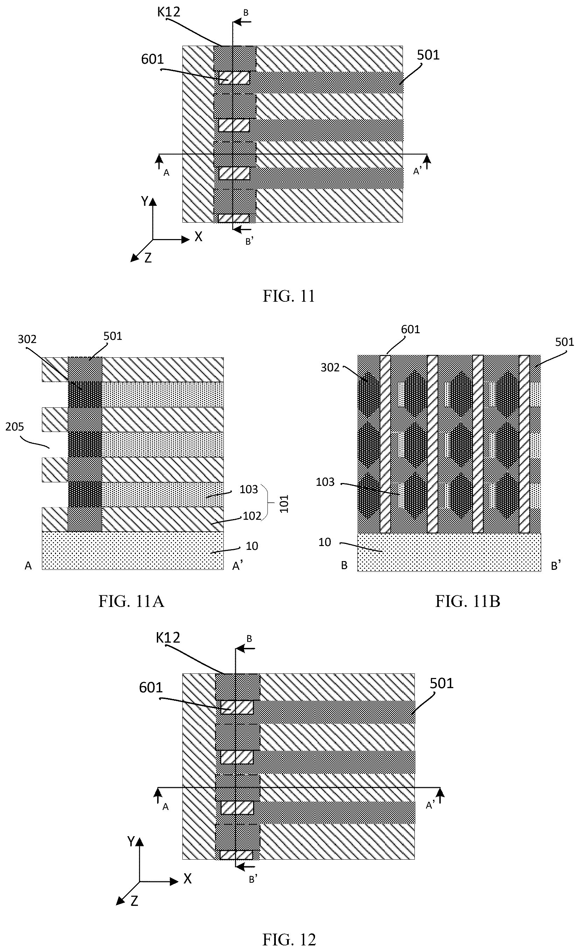

Referring to FIG. 11, FIG. 11A, and FIG. 11B, the second dielectric layer 103 at one end of the active pillar 302 is removed to form a first recess 205. As shown in FIG. 11A, the second dielectric layer 103 on the left side of the active pillar 302 is removed to form the first recess 205.

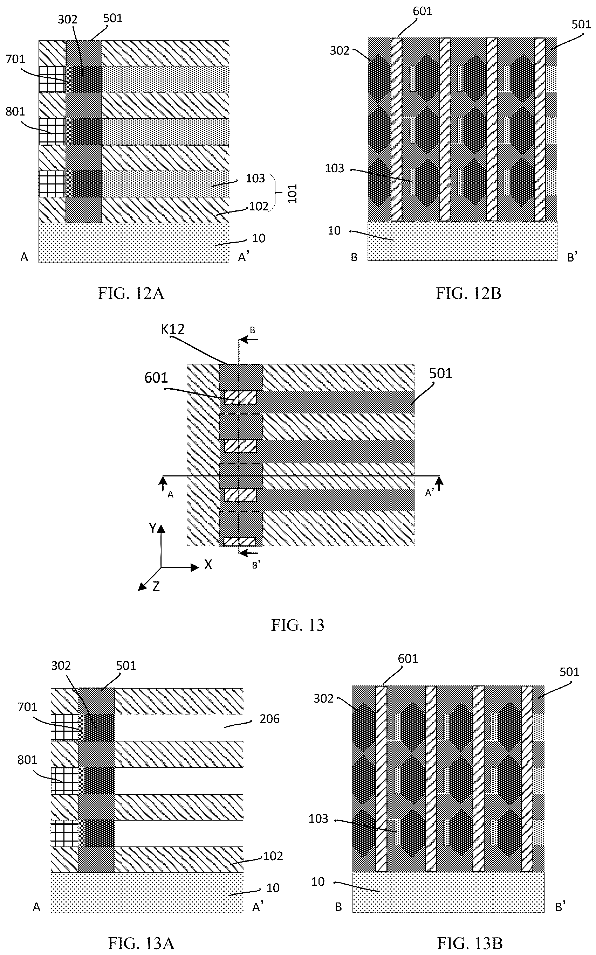

Referring to FIG. 12, FIG. 12A, and FIG. 12B, one end of the active pillar 302 is doped through the first recess 205 to form a first doped region 701. A bit line structure 801 is formed in the first recess 205. The bit line structure 801 is electrically connected to the first doped region 701.

Referring to FIG. 13, FIG. 13A, and FIG. 13B, the second dielectric layer 103 at the other end of the active pillar 302 is removed to form a second recess 206. As shown in FIG. 13A, the second dielectric layer 103 on the right side of the active pillar 302 is removed to form the second recess 206.

Referring to FIG. 14, FIG. 14A, and FIG. 14B, the other end of the active pillar 302 is doped through the second recess 206 to form a second doped region 702. A capacitor structure 901 is formed in the second recess 206. The capacitor structure 901 is electrically connected to the second doped region 702. The capacitor structure 901 and the bit line structure 801 electrically connected to the same active pillar 302 are located at the same layer, and the word line structure 601 is located on one side of the active pillar 302.

In the present application, a stack structure is formed by first dielectric layers and second dielectric layers, first openings are dug in the stack structure, and then initial active pillars are formed in the first openings by using a base substrate through an epitaxial process. The initial active pillars are etched away to form active pillars through second openings. The second dielectric layer on the left and right sides of the active pillar is etched and removed to form a first recess and a second recess, and a bit line structure and a capacitor structure are formed respectively in the first recess and the second recess, thereby reducing process time, lowering process complexity, and improving process precision. In addition, the second dielectric layer can be removed by selfaligned etching to form the first recess and the second recess, and the bit line structure and a word line structure are formed in the first recess and the second recess, such that the yield of the semiconductor structure is improved, and the device performance is enhanced.

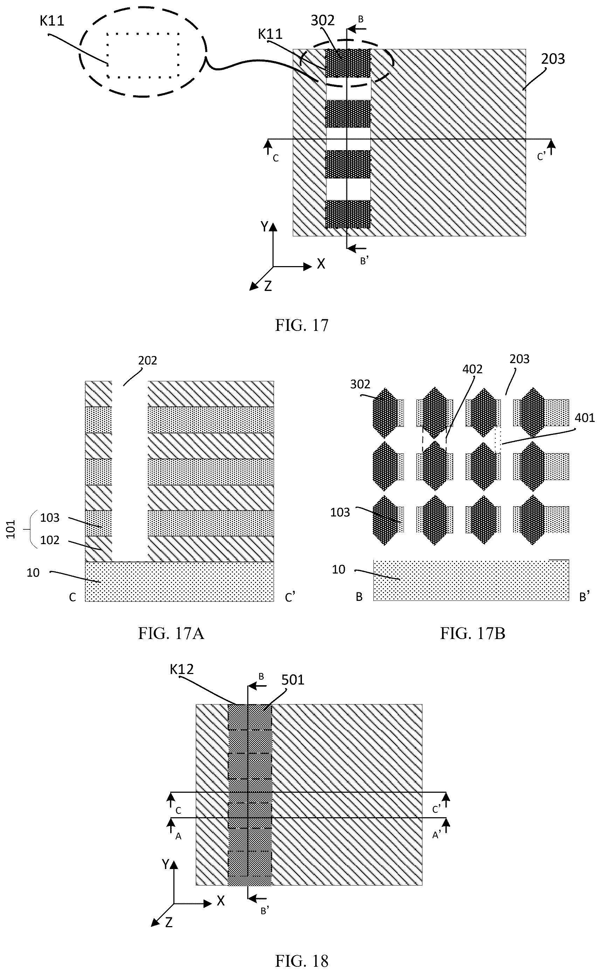

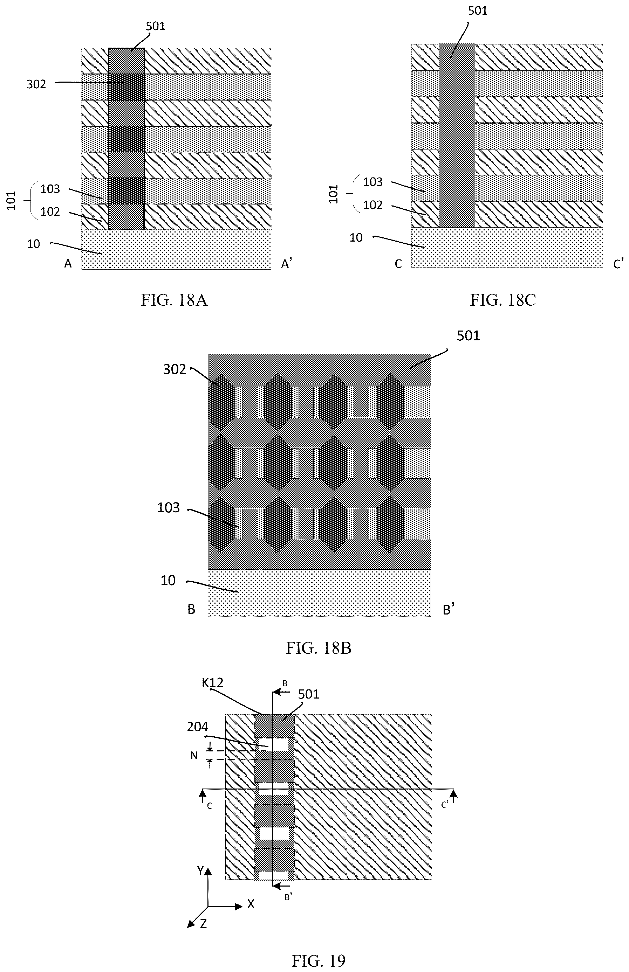

FIGS. 15 to 24 are top views of process flow diagrams of a semiconductor structure according to another embodiment of the present disclosure. FIG. 18A, FIG. 21A, FIG. 22A, FIG. 23A, and FIG. 24A are schematic diagrams of cross-sectional structures taken in the direction of A-A' in FIG. 18, FIG. 21, FIG. 22, FIG. 23, and FIG. 24, respectively; FIG. 15B, FIG. 16B, FIG. 17B, FIG. 18B, FIG. 19B, FIG. 20B, FIG. 21B, FIG. 22B, FIG. 23B, and FIG. 24B are schematic diagrams of cross-sectional structures taken in the direction of B-B' in FIG. 15, FIG. 16, FIG. 17, FIG. 18, FIG. 19, FIG. 20, FIG. 21, FIG. 22, FIG. 23, and FIG. 24, respectively; FIG. 15A, FIG. 16A, FIG. 17A, FIG. 18C, FIG. 19A, and FIG. 20A are schematic diagrams of cross-sectional structures taken in the direction of C-C' in FIG. 15, FIG. 16, FIG. 17, FIG. 18, FIG. 19, and FIG. 20, respectively.

Since some process steps of this embodiment are the same as or correspond to those of the previous embodiment, reference can be made to the corresponding descriptions of the foregoing embodiment for the content that is the same as or that corresponds to the content of the previous embodiment. The differences in this embodiment of the present disclosure are described in more detail below with reference to the drawings.

Specifically, referring to FIG. 15, FIG. 15A, and FIG. 15B, second openings 202 are formed. The second opening 202 is located between adjacent initial active pillars 301. The dimension of the second opening 202 in the second direction Y is less than the distance between adjacent initial active pillars 301. Different from the previous embodiment, in this embodiment, both ends of the second opening 202 in the first direction X are aligned with both ends of the initial active pillar 301 in the first direction X. That is, as shown in FIG. 15, the left side and the right side of the initial active pillar 301 are present in the first direction X, the leftmost side of the second opening 202 in the first direction X is aligned with the left side of the initial active pillar 301, and the rightmost side of the second opening 202 in the first direction X is aligned with the right side of the initial active pillar 301.

A first distance M is present between the second opening 202 and the initial active pillar 301. The second opening 202 extends from the top of the stack structure 101 to the top of the base substrate 10 in the third direction Z. The second opening 202 is located between two adjacent initial active pillars 301 but does not expose the side walls of the initial active pillars 301. As shown in FIG. 15B, the stack structure 101 with the thickness of M is present on the left and right sides of the initial active pillar 301, and the stack structure 101 is formed by stacking the first dielectric layers 102 and the second dielectric layers 103. The presence of the first distance M may provide a basis for the subsequent generation of an active pillar.

Referring to FIG. 16, FIG. 16A, and FIG. 16B, the first dielectric layers 102 on the side wall of the initial active pillar 301 are etched and removed through the second opening 202 to form notches 401. The notch 401 exposes the side wall of the initial active pillar 301. The notches 401 are formed on both sides of the initial active pillar 301 and spaced apart in the third direction. The notches 401 further ream the second opening 202 to form an expanded second opening 202' .

Referring to FIG. 17, FIG. 17A, and FIG. 17B, the initial active pillar 301 is etched to form an active pillar 302 through the notches 401. The active pillars 302 form gaps 402 in the third direction Z. The side walls of the active pillar 302 in the second direction Y are covered by the second dielectric layers 103. As shown in FIG. 15B, the second dielectric layer 103 with the thickness of M is present on the left and right sides of the initial active pillar 301, since the second dielectric layer 103 can protect the initial active pillar 301 from damage to the side walls during the process of etching the initial active pillar 301 to form the active pillar 302. In addition, the second dielectric layers 103 also provide self-alignment for the process of etching to form the active pillar 302. The difference in etching selectivities of the second dielectric layer 103 and the initial active pillar 301 enables the etching solution to etch only the initial active pillar 301 without etching the second dielectric layer 103, allowing the initial active pillar 301 to be etched away to form the active pillar 302. Referring to FIG. 15, FIG. 15A, and FIG. 15B, and referring to FIG. 17, FIG. 17A, and FIG. 17B, the notches 401, the gaps 402, and the second openings 202 together form a third opening 203. The cross section of the active pillar 302 in the second direction may be quadrilateral or hexagonal. As shown in FIG. 17B, the cross section of the active pillar 302 in the second direction is hexagonal. The initial active pillar 301 interposed between the second dielectric layers 103 is preferentially etched during the etching process mainly due to the blocking of the second dielectric layer 103 and the difference in etching selectivities of the second dielectric layer 103 and the initial active pillar 301. As the etching progresses, the etching rate slows down accordingly, such that the initial active pillar 301 forms a certain slope and eventually takes the shape of a hexagon as shown in FIG. 17B. Certainly, if the etching further progresses, the vertex corners of the hexagon at both ends distal to the second dielectric layer 103 may also be removed, thereby further forming a quadrilateral. The cross section of the active pillar 302 in the second direction is preferably hexagonal since the hexagon can provide more process space to increase the contact area in the subsequent process of forming a bit line structure and a capacitor structure on both ends of the active pillar, thereby further reducing the contact resistance. In addition, it should be noted that the dashed box K11 in the enlarged view in FIG. 17 indicates that since part of the top of the initial active pillar 301 is removed to form the gap 402, the active pillar 302 below can be seen through the gap 402, and the active pillar 302 shown in the dashed box K11 is an active pillar at the next layer.

Referring to FIG. 18, FIG. 18A, FIG. 18C, and FIG. 18B, a third dielectric layer 501 is formed in the third opening 203. The third dielectric layer 501 fills the third opening 203. The dashed box K12 indicates the position of the active pillar 302 present below the third dielectric layer 501 after the third dielectric layer 501 is formed above. As shown in FIG. 18A, the second dielectric layer 103 is present on the left and right sides of the active pillar 302, the third dielectric layer 501 is present on the upper and lower sides of the active pillar 302, and the first dielectric layer 102 is present on the left and right sides of the third dielectric layer 501. The first dielectric layer 102 and the third dielectric layer 501 may be made of the same material or different materials, with the same material being preferred. If the materials of the first dielectric layer 102 and the third dielectric layer 501 are different, it is necessary to ensure that the etching selectivities of the first dielectric layer 102, the third dielectric layer 501, and the second dielectric layer 103 are large.

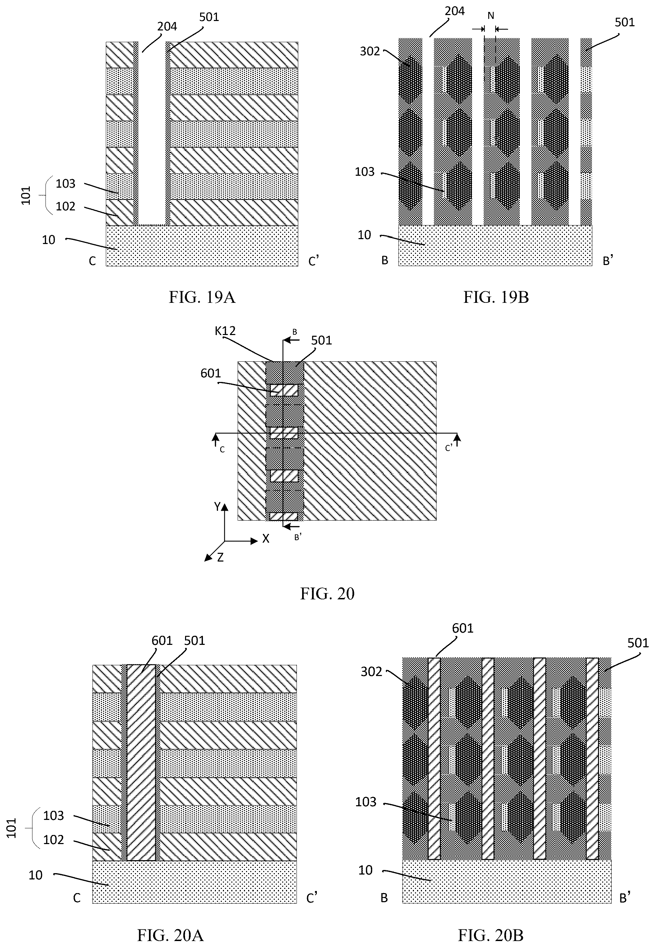

Referring to FIG. 19, FIG. 19A, and FIG. 19B, fourth openings 204 are formed. The fourth opening 204 is adjacent to one side of the active pillar 302 and exposes part of the side wall of the active pillar 302. A second distance N is present between the fourth opening 204 and a non-adjacent active pillar 302. The fourth opening 204 extends to the bottom of the stack structure 101 in the third direction Z.

Referring to FIG. 20, FIG. 20A, and FIG. 20B, word line structures 601 are formed in the fourth opening 204. The word line structure 601 is in contact with one side wall of the active pillar 302. As shown in the figure, the word line structure 601 is in contact with the right side wall of the active pillar 302, and in other embodiments, the word line structure 601 may be also in contact with the left side wall of the active pillar 302, which mainly depends on the position of the fourth opening 204. The arrangement of the word line structure 601 on either the left or right side of the active pillar 302 does not affect the performance of the word line structure itself, and the layout is mainly determined based on the performance requirements of the overall structure. It should be noted that before forming the word line structure 601, a gate dielectric layer is further formed in the fourth opening 204. That is, the gate dielectric layer is present between the word line structure 601 and the active pillar 302.

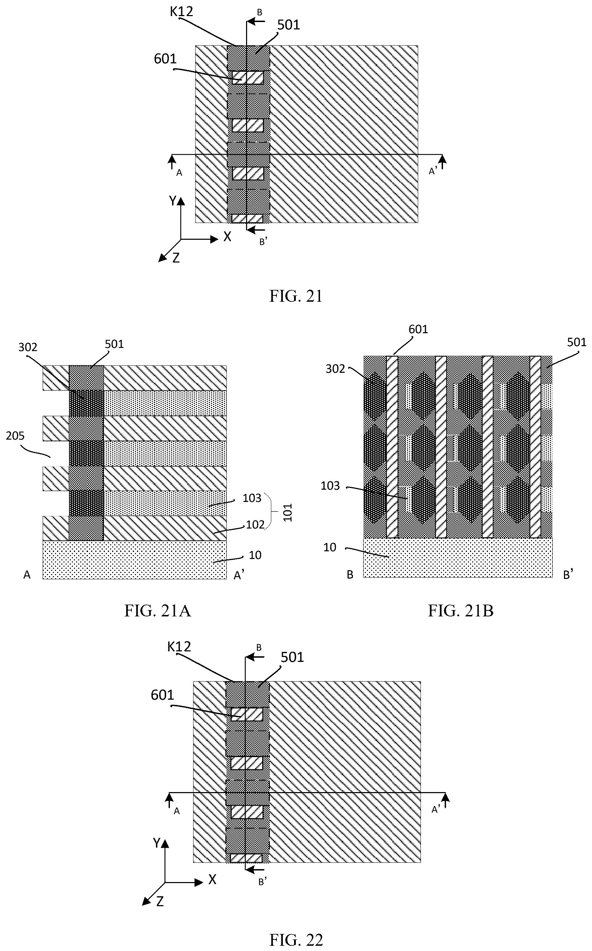

Referring to FIG. 21, FIG. 21A, and FIG. 21B, the second dielectric layer 103 at one end of the active pillar 302 is removed to form a first recess 205. As shown in FIG. 21A, the second dielectric layer 103 on the left side of the active pillar 302 is removed to form the first recess 205.

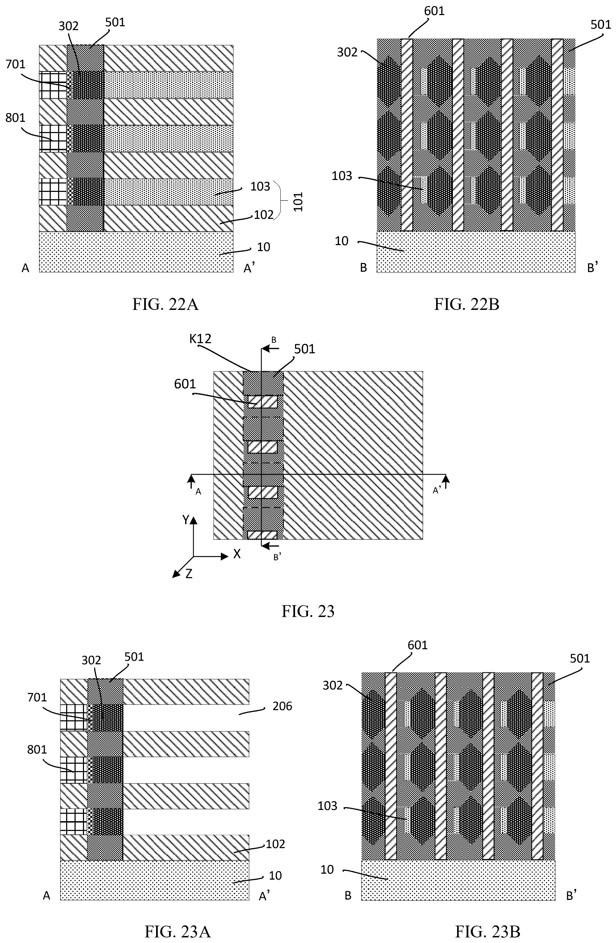

Referring to FIG. 22, FIG. 22A, and FIG. 22B, one end of the active pillar 302 is doped through the first recess 205 to form a first doped region 701. A bit line structure 801 is formed in the first recess 205. The bit line structure 801 is electrically connected to the first doped region 701.

Referring to FIG. 23, FIG. 23A, and FIG. 23B, the second dielectric layer 103 at the other end of the active pillar 302 is removed to form a second recess 206. As shown in FIG. 23A, the second dielectric layer 103 on the right side of the active pillar 302 is removed to form the second recess 206.

Referring to FIG. 24, FIG. 24A, and FIG. 24B, the other end of the active pillar 302 is doped through the second recess 206 to form a second doped region 702. A capacitor structure 901 is formed in the second recess 206. The capacitor structure 901 is electrically connected to the second doped region 702. The capacitor structure 901 and the bit line structure 801 electrically connected to the same active pillar 302 are located at the same layer, and the word line structure 601 is located on one side of the active pillar 302.

In the present application, a stack structure is formed by first dielectric layers and second dielectric layers, first openings are dug in the stack structure, and then initial active pillars are formed in the first openings by using a base substrate through an epitaxial process. The initial active pillars are etched away to form active pillars through second openings. The second dielectric layer on the left and right sides of the active pillar is etched and removed to form a first recess and a second recess, and a bit line structure and a capacitor structure are formed respectively in the first recess and the second recess. This method has at least the following advantages: First, in the present application, the stack structure of the first dielectric layers and the second dielectric layers are used and can be formed by a conventional deposition process, and the process is easy to control and time-efficient. Second, in the present application, only the initial active pillar needs to be epitaxially generated in the first opening by using a silicon base substrate, without the need to epitaxially grow Si and SiGe, thereby reducing process time and process complexity. Third, in the present application, based on the large etching selectivities of the first dielectric layer and the second dielectric layer, the etching and self-alignment are performed to form the capacitor structure and the bit line structure, such that the process is simplified and easy to control, thereby further improving process precision. In the present application, during the process of forming the active pillar, the stack structure is used to provide support, and there is no need to form an additional support layer to support the remaining material, such that the process is simplified. Apart from the formation of the active pillar, no additional processes are required to provide support during the subsequent processes for forming the bit line structure and the capacitor structure, such that the overall process time is shortened, and the simplified process improves the efficiency and yield of semiconductor device manufacturing.

FIG. 25 is a three-dimensional schematic diagram of a semiconductor structure according to an embodiment of the present disclosure; FIG. 25a is a three-dimensional schematic diagram of an overall structure. To clearly illustrate the obscured parts in FIG. 25a, FIG. 25a is exploded and shown as FIG. 25b. Specifically, referring to FIG. 25, the semiconductor structure of the present application includes: a base substrate 10, a plurality of word line structures 601 perpendicular to the base substrate 10, a plurality of active pillars 302, a plurality of bit line structures 801, and a plurality of capacitor structures 901. The word line structures 601 are spaced apart in a second direction Y; the active pillars 302 extend in a first direction X, the active pillars 302 are spaced apart in both the second direction Y and a third direction Z, and the third direction Z is perpendicular to the first direction X and the second direction Y; the word line structure 601 is disposed proximal to one side of the active pillar 302; the bit line structures 801 extend in the second direction Y and are spaced apart in the third direction Z, and the bit line structure 801 is electrically connected to one end of the active pillar 302; the capacitor structures 901 extend in the first direction X and are spaced apart in both the second direction Y and the third direction Z, and the capacitor structure 901 is electrically connected to the other end of the active pillar 302. As shown in FIG. 25a, the word line structure is disposed on one side of the active pillar 302. In addition, from the front view, the word line structure obscures the active pillar 302. To clearly illustrate the obscured active pillar 302 in FIG. 25a, FIG. 25a is now exploded to form FIG. 25b. It should be noted that in FIG. 25b, the word line structure 601 being distal to the active pillar is only for the convenience of clearly illustrating the obscured parts in FIG. 25a. In the actual structure, the word line structure 601 is disposed adjacent to the active pillar 302, as shown in FIG. 25a.

In some embodiments, specifically, referring to FIG. 14A and FIG. 25, multiple active pillars 302 spaced apart in the second direction Y are electrically connected to the same bit line structure 801, and each active pillar 302 is electrically connected to one capacitor structure 901. The active pillars 302 electrically connected to the same bit line structure 801, the capacitor structure 901 electrically connected to the active pillar 302, and the bit line structure 801 are all located at the same tier. Specifically, as shown in FIG. 14A, the same tier means that the capacitor structure 901 and the bit line structure 801 electrically connected to the same active pillar 302 are located at the same layer.

In some embodiments, the semiconductor structure further includes first doped regions 701 and second doped regions 702. The first doped region 701 is located at one end of the active pillar 302 and electrically connected to the bit line structure 801; the second doped region 702 is located at the other end of the active pillar 302 and electrically connected to the capacitor structure 901. It should be noted that the first doped region 701 and the second doped region 702 in the embodiments of the present application are only for illustration, and specifically, the lengths of the first doped region 701 and the second doped region 702 may be set according to the process requirements.

In some embodiments, the semiconductor structure further includes: channel regions 20 each disposed proximal to the word line structure 601. The channel region 20 is located on the active pillar 302 between the first doped region 701 and the second doped region 702 and proximal to the word line structure 601. Specifically, as shown in FIG. 25a, the dashed box shows the position of the channel region 20.

In some embodiments, the cross section of the active pillar 302 in the second direction Y may be quadrilateral or hexagonal. Referring to FIG. 14B, in this embodiment, the cross section of the active pillar 302 in the second direction is preferably hexagonal since the hexagon can provide more process space for the active pillar 302, the capacitor structure 901, and the bit line structure 801 to increase the contact area, thereby further reducing the contact resistance.

The semiconductor structure in the present application may be a three-dimensional dynamic random access memory (3D DRAM), and specifically, may be a 3D DRAM including a multilayer horizontal cell (multilayer horizontal cell, MHC). In the present application, the formation process of the semiconductor structure is simplified and the performance of the semiconductor device is enhanced.

The various semiconductor structures shown in the specific embodiments can be used for an electronic device having a memory function. The electronic device may be a terminal device, for example, a mobile phone, a tablet computer, a smart bracelet, a personal computer (personal computer, PC), a server, or a workstation. The memory function in the electronic device can be implemented by using the following memories: a dynamic random access memory (DRAM), a ferroelectric random access memory (FRAM), a phase change memory (PCM), a magnetic random access memory (MRAM), or a resistive random access memory (RRAM).

Those of ordinary skill in the art can understand that the foregoing implementations are specific embodiments of practicing the present disclosure, while in practical application, various changes can be made to the implementations in form and detail without departing from the spirit and scope of the present disclosure. Any person skilled in the art can make various changes and modifications without departing from the spirit and scope of the present disclosure, and the protection scope of the present disclosure shall be defined by the appended claims.

## Claims

1. A method for manufacturing a semiconductor structure, comprising:
providing a base substrate (10);
forming a stack structure (101) on the base substrate (10), wherein the stack structure (101) is formed by stacking first dielectric layers (102) and second dielectric layers (103) in a third direction (Z), wherein the third direction (Z) is perpendicular to a surface of the base substrate (10);
forming at least one first opening (201), wherein the first opening (201) extends from a top of the stack structure (101) to a top of the base substrate (10) in the third direction (Z), and a plurality of first openings (201) are spaced apart in a second direction (Y), wherein the second direction (Y) is parallel to the surface of the base substrate (10), and the second direction (Y) is perpendicular to the third direction (Z);
forming initial active pillars (301), wherein each of the initial active pillars (301) fills one of the plurality of first openings (201);
forming second openings (202), wherein each of the second openings (202) is located between adjacent initial active pillars (301), a dimension of the second opening (202) in the second direction (Y) is less than a distance between the adjacent initial active pillars (301), a first distance (M) is present between the second opening (202) and one of the initial active pillars (301), and the second opening (202) extends from the top of the stack structure (101) to the top of the base substrate (10) in the third direction (Z);
removing parts of the initial active pillars (301) to form active pillars (302), wherein the active pillars (302) are spaced apart in both the second direction (Y) and the third direction (Z);
forming word line structures (601), wherein each of the word line structures (601) is disposed on one side of one of the active pillars (302) and extends in the third direction (Z);
forming bit line structures (801), wherein each of the bit line structures (801) is electrically connected to one end of one of the active pillars (302), and the bit line structure (801) extends in the second direction (Y); and
forming capacitor structures (901), wherein each of the capacitor structures (901) is electrically connected to the other end of one of the active pillars (302), and the capacitor structure (901) extends in a first direction (X), wherein the first direction (X) is perpendicular to a plane formed with the third direction (Z) and the second direction (Y).

2. The method for manufacturing a semiconductor structure according to claim 1, wherein both ends of each of the second openings (202) in the first direction (X) are aligned with both ends of one of the initial active pillars (301) in the first direction (X); or one end of the second opening (202) in the first direction (X) is aligned with one end of the initial active pillar (301) closest to one edge of the stack structure (101), and the other end of the second opening (202) extends to the other edge of the stack structure (101) in the first direction (X).

3. The method for manufacturing a semiconductor structure according to claim 2, wherein removing parts of the initial active pillars (301) to form the active pillars (302) specifically comprises:
exposing, by the second openings (202), the stack structure (101) surrounding the initial active pillars (301), and etching and removing parts of the first dielectric layers (102) on side walls of the initial active pillars (301) to form notches (401), wherein the notches (401) expose the side walls of the initial active pillars (301), and the notches (401) are spaced apart in the third direction (Z); and
etching the initial active pillars (301) to form the active pillars (302) through the notches (401), wherein the active pillars (302) form gaps (402) in the third direction (Z), and side walls of the active pillars (302) are covered by the second dielectric layers (103); and
the notches (401), the gaps (402), and the second openings (202) together form a third opening (203).

4. The method for manufacturing a semiconductor structure according to claim 3, after forming the active pillars (302) and before forming the word line structures (601), further comprising:
forming a third dielectric layer (501), wherein the third dielectric layer (501) fills the third opening (203);
forming fourth openings (204), wherein each of the fourth openings (204) is adjacent to one side of one of the active pillars (302) and exposes part of the side wall of the active pillar (302), a second distance (N) is present between the fourth opening (204) and a non-adjacent active pillar (302), and the fourth opening (204) extends to a bottom of the stack structure (101) in the third direction (Z); and
forming one of the word line structures (601) in each of the fourth openings (204).

5. The method for manufacturing a semiconductor structure according to claim 4, wherein forming the bit line structures (801) specifically comprises:
removing the second dielectric layers (103) at one end of the active pillars (302) to form first recesses (205);
doping one end of the active pillars (302) through the first recesses (205) to form first doped regions (701); and
forming one of the bit line structures (801) in each of the first recesses (205), wherein each of the bit line structures (801) is electrically connected to one of the first doped regions (701).

6. The method for manufacturing a semiconductor structure according to claim 5, wherein forming the capacitor structures (901) specifically comprises:
removing the second dielectric layers (103) at the other end of the active pillars (302) to form second recesses (206);
doping the other end of the active pillars (302) through the second recesses (206) to form second doped regions (702); and
forming one of the capacitor structures (901) in each of the second recesses (206), wherein each of the capacitor structures (901) is electrically connected to one of the second doped regions (702).

7. The method for manufacturing a semiconductor structure according to claim 1, wherein the initial active pillars (301) are generated through an epitaxial process, and a cross section of each of the active pillars (302) in the second direction (Y) may be quadrilateral or hexagonal.

8. A semiconductor structure, comprising:
a base substrate (10);
a plurality of word line structures (601) perpendicular to the base substrate (10), wherein the plurality of word line structures (601) are spaced apart in a second direction (Y);
a plurality of active pillars (302), wherein the plurality of active pillars (302) extend in a first direction (X); the plurality of active pillars (302) are spaced apart in both the second direction (Y) and a third direction (Z), the third direction (Z) being perpendicular to the first direction (X) and the second direction (Y); and each of the plurality of word line structures (601) is disposed proximal to one side of one of the plurality of active pillars (302);
a plurality of bit line structures (801), wherein the plurality of bit line structures (801) extend in the second direction (Y) and are spaced apart in the third direction (Z), and each of the plurality of bit line structures (801) is electrically connected to one end of one of the plurality of active pillars (302); and
a plurality of capacitor structures (901), wherein the plurality of capacitor structures (901) extend in the first direction (X) and are spaced apart in both the second direction (Y) and the third direction (Z), and each of the plurality of capacitor structures (901) is electrically connected to the other end of one of the plurality of active pillars (302).

9. The semiconductor structure according to claim 8, wherein multiple active pillars (302) spaced apart in the second direction (Y) among the plurality of active pillars are all electrically connected to a same bit line structure (801), each of the multiple active pillars (302) is electrically connected to one capacitor structure (901), and the active pillars (302) electrically connected to the same bit line structure (801), the capacitor structure (901) electrically connected to the active pillar (302), and the bit line structure (801) are all located at a same tier.

10. The semiconductor structure according to claim 8, further comprising:
first doped regions (701), wherein each of the first doped regions (701) is located at one end of one of the plurality of active pillars (302) and electrically connected to one of the plurality of bit line structures (801); and
second doped regions (702), wherein each of the second doped regions (702) is located at the other end of one of the plurality of active pillars (302) and electrically connected to one of the plurality of capacitor structures (901).

11. The semiconductor structure according to claim 10, further comprising:
channel regions each disposed proximal to one of the plurality of word line structures (601), wherein each of the channel regions is located on one of the plurality of active pillars (302) between one of the first doped regions (701) and one of the second doped regions (702) and proximal to one of the plurality of word line structures (601).

12. The semiconductor structure according to claim 8, wherein a cross section of each of the plurality of active pillars (302) in the second direction (Y) may be quadrilateral or hexagonal.
